# EUROPEAN PATENT APPLICATION

(11) **EP 2 110 422 A1**
(43) Date of publication of application: **21.10.2009**
(21) Application number: 08703812.1
(22) Date of filing: 24.01.2008
(51) Int. Cl.: C09J 7/02, C09J 11/04, C09J 133/06, C09J 183/04

(54) **ADHESIVE TAPE**

(30) Priority: 07.02.2007 JP 2007027480
(71) Applicant: Nitto Denko Corporation, Ibaraki-shi Osaka 567-8680 (JP)
(72) Inventor: TERADA, Yoshio, Ibaraki-shi Osaka 567-8680 (JP); SUGO, Yuki, Ibaraki-shi Osaka 567-8680 (JP); KOUNO, Toshiki, Ibaraki-shi Osaka 567-8680 (JP)
(74) Representative: Ilgart, Jean-Christophe
(86) International application number: PCT/JP2008/050985
(87) International publication number: WO 2008/096610

(57) **Abstract**

Disclosed is a pressure-sensitive adhesive tape which has a sufficient pressure-sensitive adhesive strength for an adherend, is excellent in heat resistance, and can be easily peeled without leaving a pressure-sensitive adhesive residue on the adherend particularly upon peeling. The pressure-sensitive adhesive tape of the present invention includes, on a base material sheet, a pressure-sensitive adhesive layer containing a pressure-sensitive adhesive composition and a lipophilic layered clay mineral dispersed in the pressure-sensitive adhesive composition, in which pieces of the layered clay mineral are arranged substantially perpendicular to the base material sheet.

## Description

### Technical Field

The present invention relates to a pressure-sensitive adhesive tape, and more specifically, to a pressure-sensitive adhesive tape which has a sufficient pressure-sensitive adhesive strength for an adherend, is excellent in heat resistance, and can be easily peeled without leaving a pressure-sensitive adhesive residue on the adherend particularly upon peeling.

### Background Art

The applications of a pressure-sensitive adhesive tape have been covering a broad spectrum in recent years. The pressure-sensitive adhesive tape has been used in a wide variety of fields such as the production of electronic parts, structures, and automobiles. In most of those applications, a large stress is applied to the pressure-sensitive adhesive tape at the time of the use of the pressure-sensitive adhesive tape, and the pressure-sensitive adhesive tape is used at high temperatures. Accordingly, a pressure-sensitive adhesive layer used in the pressure-sensitive adhesive tape is requested to have a high cohesive strength and heat resistance. Since the production of an electronic part, a semiconductor device, or a flat display such as an LCD or PDP involves a particularly large number of processes to be performed at high temperatures of 100°C or higher, a pressure-sensitive adhesive tape having the following characteristics has been strongly requested: the pressure-sensitive adhesive tape exerts a sufficient pressure-sensitive adhesive strength and a sufficient cohesive strength at high temperatures, and can be easily peeled and removed from an adherend after its use.

However, a pressure-sensitive adhesive layer in a conventional pressure-sensitive adhesive tape involves problems that the layer is poor in pressure-sensitive adhesive strength and cohesive strength at high temperatures.

In view of the foregoing, investigations have been conducted on an improvement in heat resistance of the pressure-sensitive adhesive layer by the blending of the layer with various inorganic fillers. For example, it has been reported that the pressure-sensitive adhesive layer shows an improved pressure-sensitive adhesive strength and an improved cohesive strength at high temperatures when a lipophilic layered clay mineral is used as an inorganic filler, and the lipophilic layered clay mineral is dispersed in the pressure-sensitive adhesive layer (see Patent Documents 1 and 2).

The above-mentioned approach involving dispersing the lipophilic layered clay mineral in the pressure-sensitive adhesive layer is an effective approach to improving the pressure-sensitive adhesive strength and cohesive strength of the pressure-sensitive adhesive layer at high temperatures. However, when the pressure-sensitive adhesive tape is peeled and removed from an adherend at the time of reworking or after the completion of a production process, the following problem arises: the pressure-sensitive adhesive layer containing the lipophilic layered clay mineral undergoes a cohesive failure to leave a pressure-sensitive adhesive residue (paste residue) on the adherend.
Patent Document 1: JP 2005-344008 A
Patent Document 2: JP 2005-154581 A

### Disclosure of the Invention

### Problems to be solved by the Invention

An object of the present invention is to provide a pressure-sensitive adhesive tape which has a sufficient pressure-sensitive adhesive strength for an adherend, is excellent in heat resistance, and can be easily peeled without leaving a pressure-sensitive adhesive residue on the adherend particularly upon peeling.

### Means for solving the Problems

The inventors of the present invention have conducted investigations on a cause for the cohesive failure of a pressure-sensitive adhesive layer containing a lipophilic layered clay mineral when a pressure-sensitive adhesive tape is peeled and removed from an adherend. As a result, the inventors have found that the pieces of the lipophilic layered clay mineral are dispersed in the pressure-sensitive adhesive layer while being arranged substantially horizontal to a base material film. The pieces of the lipophilic layered clay mineral, if dispersed while being arranged substantially horizontal to the base material film, exert extremely high toughness against a horizontal stress. However, such arrangement structure of the lipophilic layered clay mineral is extremely vulnerable to an upward (vertical) stress to be produced upon peeling and removal of the pressure-sensitive adhesive tape from the adherend. In other words, the inventors have considered that the direction in which the pieces of the lipophilic layered clay mineral are arranged in the pressure-sensitive adhesive layer is a cause for the cohesive failure upon peeling and removal of the pressure-sensitive adhesive tape from the adherend.

In view of the foregoing, the inventors have hit on an idea that, in a pressure-sensitive adhesive tape having, on a base material sheet, a pressure-sensitive adhesive layer containing a pressure-sensitive adhesive composition and a lipophilic layered clay mineral dispersed in the pressure-sensitive adhesive composition, the pieces of the lipophilic layered clay mineral in the pressure-sensitive adhesive layer should be arranged substantially perpendicular to the base material sheet. As a result of investigations on the idea, the inventors have found that the pressure-sensitive adhesive tape can be easily peeled without leaving a pressure-sensitive adhesive residue (paste residue) on an adherend upon peeling and removal of the pressure-sensitive adhesive tape from the adherend. Thus, the inventors have completed the present invention.

A pressure-sensitive adhesive tape of the present invention includes, on a base material sheet, a pressure-sensitive adhesive layer containing a pressure-sensitive adhesive composition and a lipophilic layered clay mineral dispersed in the pressure-sensitive adhesive composition, in which pieces of the layered clay mineral are arranged substantially perpendicular to the base material sheet.

In a preferred embodiment, the layered clay mineral includes a smectite-based clay mineral and/or a mica-based clay mineral.

In a preferred embodiment, 2 to 20 parts by weight of the layered clay mineral are incorporated into 100 parts by weight of the pressure-sensitive adhesive composition.

In a preferred embodiment, the pressure-sensitive adhesive composition includes an acrylic pressure-sensitive adhesive composition formed of a monomer composition mainly composed of an alkyl (meth) acrylate ester of an alkyl alcohol having 4 to 14 carbon atoms.
In a preferred embodiment, the pressure-sensitive adhesive composition includes a silicone-based pressure-sensitive adhesive composition.

In a preferred embodiment, the pressure-sensitive adhesive tape is used in producing an electronic part.

### Effect of the Invention

According to the present invention, there can be provided a pressure-sensitive adhesive tape which has a sufficient pressure-sensitive adhesive strength for an adherend, is excellent in heat resistance, and can be easily peeled without leaving a pressure-sensitive adhesive residue on the adherend particularly upon peeling.
In a pressure-sensitive adhesive tape having, on a base material sheet, a pressure-sensitive adhesive layer containing a pressure-sensitive adhesive composition and a lipophilic layered clay mineral dispersed in the pressure-sensitive adhesive composition, the above-mentioned effect can be expressed effectively by arranging the pieces of the lipophilic layered clay mineral in the pressure-sensitive adhesive layer substantially perpendicular to the base material sheet.

### Brief Description of the Drawings

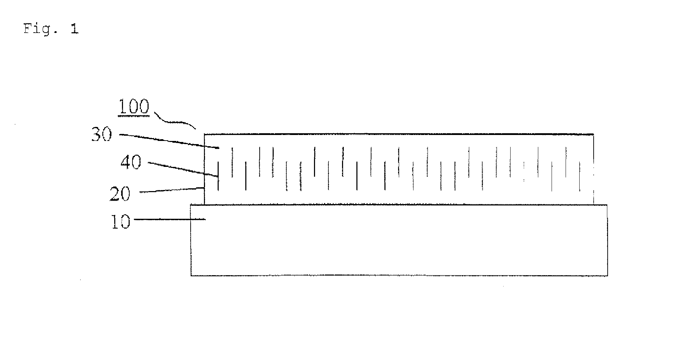

Fig. **1** is a schematic sectional view of a pressure-sensitive adhesive tape according to a preferred embodiment of the present invention.

### Description of the Reference Numerals

- **10**: base material sheet
- **20**: pressure-sensitive adhesive layer
- **30**: pressure-sensitive adhesive composition
- **40**: lipophilic layered clay mineral
- **100**: pressure-sensitive adhesive tape

### Best Mode for carrying out the Invention

A pressure-sensitive adhesive tape of the present invention has, on a base material sheet, a pressure-sensitive adhesive layer containing a pressure-sensitive adhesive composition and a lipophilic layered clay mineral dispersed in the pressure-sensitive adhesive composition. Any appropriate thickness can be adopted as the thickness of the pressure-sensitive adhesive layer. The thickness of the pressure-sensitive adhesive layer is preferably 2 to 50 µm. Fig. **1** illustrates one preferred embodiment of the pressure-sensitive adhesive tape of the present invention. As shown in Fig. **1****,** a pressure-sensitive adhesive tape **100** of the present invention has a pressure-sensitive adhesive layer **20** on a base material sheet **10,** and the pressure-sensitive adhesive layer **20** contains a pressure-sensitive adhesive composition **30** and a lipophilic layered clay mineral **40.** The pieces of the lipophilic layered clay mineral **40** are arranged substantially perpendicular to the base material sheet **10.**

Any appropriate composition can be adopted as the above pressure-sensitive adhesive composition as long as the pressure-sensitive adhesive layer can be formed of the composition. Examples of the above pressure-sensitive adhesive composition include: an acrylic pressure-sensitive adhesive composition formed of a monomer composition mainly composed of an alkyl (meth) acrylate ester of an alkyl alcohol having 4 to 14 carbon atoms; and a silicone-based pressure-sensitive adhesive composition.

The content of the alkyl (meth)acrylate ester of an alkyl alcohol having 4 to 14 carbon atoms in the monomer composition as a raw material for the above acrylic pressure-sensitive adhesive composition is preferably 50 to 100 wt%, more preferably 70 to 100 wt%, still more preferably 80 to 100 wt%, still more preferably 85 to 100 wt%, still more preferably 90 to 100 wt%, still more preferably 95 to 100 wt%, particularly preferably 97 to 100 wt%, or most preferably 100 wt%. When the above content is less than 50 wt%, for example, the pressure-sensitive adhesive tape may be unable to exert its pressure-sensitive adhesive strength sufficiently.

Examples of the alkyl (meth) acrylate ester of an alkyl alcohol having 4 to 14 carbon atoms include alkyl esters of acrylates or methacrylates each having an alkyl group such as a butyl group, an isobutyl group, a pentyl group, an isopentyl group, a hexyl group, a heptyl group, an octyl group, an isoctyl group, a nonyl group, an isononyl group, a decyl group, or an isodecyl group, and compounds in each of which a part of the alkyl group is substituted with a hydroxyl group.

The monomer composition as a raw material of the acrylic pressure-sensitive adhesive composition may include any other appropriate monomers other than the alkyl (meth) acrylate ester of an alkyl alcohol having 4 to 14 carbon atoms. Examples of the other monomers include polar group-containing, copolymerizable monomers. Examples of the polar group-containing, copolymerizable monomers include: unsaturated acids such as (meth)acrylic acid, itaconic acid, and 2-acrylamide propane sulfonate; and hydroxyl group-containing monomers such as 2-hydroxyethyl (meth)acrylate and 2-hydroxypropyl (meth)acrylate.

When the monomer composition as a raw material for the above acrylic pressure-sensitive adhesive composition contains the above alkyl (meth) acrylate ester of an alkyl alcohol having 4 to 14 carbon atoms and the above polar group-containing,copolymerizable monomer, a weight ratio between their contents is preferably 85 to 97/15 to 3, or more preferably 90 to 95/10 to 5. When the ratio deviates from the above range, the breaking elongation of the pressure-sensitive adhesive tape may reduce, or the pressure-sensitive adhesive tape may be unable to obtain desired pressure-sensitive adhesiveness.

The above acrylic pressure-sensitive adhesive composition may contain a coupling agent. The coupling agent is effective in causing a filler having a polar group and a monomer to interact with each other. They may be used alone or in combination. The coupling agent has only to be selected as appropriate in consideration of, for example, compatibility, thickening property, and the presence or absence of gelation.

Any appropriate coupling agent can be adopted as the above coupling agent. A preferable example of the coupling agent is an organic silicon monomer having two or more different reactive groups in any one of its molecules. One of the two reactive groups in each molecule of the organic silicon monomer is a reactive group that chemically bonds to a mineral, and the other is a reactive group that chemically bonds to an organic material. Examples of the reactive group that chemically bonds to a mineral include a methoxy group, an ethoxy group, and a silanol group. Examples of the reactive group that chemically bonds to an organic material include a vinyl group, an epoxy group, a methacryl group, an amino group, and a mercapto group.

Examples of the coupling agent include vinyl trichlorsilane, vinyl tris(β-methoxyethoxy)silane, vinyl triethoxysilane, vinyl trimethoxysilane, γ-methacryloxypropyl trimethoxysilane, β-(3,4-epoxycyclohexyl)ethyl trimethoxysilane, γ-glycidoxypropyl trimethoxysilane, γ-glycidoxypropylmethyl diethoxysilane, N-β-(aminoethyl)-γ-aminopropyl trimethoxysilane, N-β-(aminoethyl)-γ-aminopropymethyl dimethoxysilane, γ-aminopropyl triethoxysilane, N-phenyl-γ-aminopropyl trimethoxysilane, γ-mercaptopropyl trimethoxysilane, γ-chloropropyl trimethoxysilane, γ-glycidoxypropyl triethoxysilane, γ-methacryloxypropylmethyl diethoxysilane, γ-methacryloxypropyl triethoxysilane, N-β-(aminoethyl)-γ-aminopropyl triethoxysilane,and γ-aminopropyl trimethoxysilane.

The content of the coupling agent is preferably 0.05 to 20 parts by weight, more preferably 0.1 to 10 parts by weight, or still more preferably 0.5 to 5 parts by weight with respect to 100 parts by weight of the above monomer composition. When the content is less than 0.05 part by weight, the coupling agent may be unable to exert its effect. When the content is 20 parts by weight or more, the pressure-sensitive adhesive layer may become vulnerable.

Any appropriate composition such as a commercially available silicone-based pressure-sensitive adhesive can be adopted as the above silicone-based pressure-sensitive adhesive composition. When the silicone-based pressure-sensitive adhesive composition is used, the heat resistance of the pressure-sensitive adhesive tape is high, and the storage modulus andpressure-sensitive adhesive strength of the pressure-sensitive adhesive tape at high temperatures easily become appropriate values.

The lipophilic layered clay mineral is obtained by subjecting a layered silicate mineral having an exchangeable cation in its crystal structure to a lipophilic treatment.

Any appropriate layered silicate mineral can be adopted as the layered silicate mineral. Examples of the above layered silicate mineral include: smectite-based clay minerals such as montmorillonite, saponite, hectorite, and stevensite; and mica-based clay minerals such as fluoro-tetrasilicic mica. They may be used alone or in combination; a mica-based clay mineral is preferably used because the pressure-sensitive adhesive tape can obtain good toughness.

The lipophilic layered clay mineral is preferably of a plate-like shape. In this case, the lipophilic layered clay mineral has a thickness of preferably about 0.1 to 10 nm, or more preferably 0.5 to 5 nm. In addition, the lipophilic layered clay mineral has a width of preferably 10 to 10, 000 nm, more preferably 20 to 7, 000 nm, or still more preferably 50 to 5, 000 nm. The terms "thickness" and "width" as used herein each refer to an average length. The average length can be determined by actual measurement with an electron microscope (TEM) photograph. When the above width exceeds 10,000 nm, the elongation of the pressure-sensitive adhesive tape may reduce. When the width is less than 10 nm, a breaking stress for the pressure-sensitive adhesive tape may increase.

The above lipophilic layered clay mineral is preferably as follows: an exchangeable cation between layers is subjected to an ion exchange treatment with an organic cation or the like so that a gap between the layers may be made lipophilic.

The exchangeable cation is a metal ion present on the surface of the crystal layer of a layered silicate mineral such as a sodium ion or a calcium ion. A lipophilic monomer cannot penetrate into a gap between layers of the layered silicate mineral because such ion is hydrophilic. Accordingly, a good dispersed product cannot be obtained. In order that the monomer may be caused to penetrate into the gap between the layers, the exchangeable cation must be subjected to ion exchange with a lipophilic, cationic surfactant or the like.

Examples of the cationic surfactant include quaternary ammonium salts and quaternary phosphonium salts.

Examples of the quaternary ammonium salt include lauryl trimethylammoniumsalts, stearyltrimethylammoniumsalts, trioctyl ammonium salts, distearyl dimethyl ammonium salts, distearyl dibenzyl ammonium salts, and ammonium salts each having a substituted propylene oxide skeleton. They may be used alone or in combination.

Examples of the quaternary phosphonium salts include decyl triphenyl phosphonium salts, methyl triphenyl phosphonium salts, lauryl trimethyl phosphonium salts, stearyl trimethyl phosphonium salts, distearyl dimethyl phosphonium salts, and distearyl dibenzyl phosphonium salts. They may be used alone or in combination.

In the pressure-sensitive adhesive tape of the present invention, the layers of the above lipophilic layered clay mineral are preferably peeled from each other to a sufficient extent before the use of the pressure-sensitive adhesive tape. Any appropriate method can be adopted as a method of peeling the layers. For example, ultrasonic peeling, high-pressure shear peeling, ultra-high speed stirring, or supercritical CO₂ stirring is employed; a high-pressure shear peeling method is particularly preferable because the method allows one to peel the layers from each other without crushing the lipophilic layered clay mineral. The layers of the lipophilic layered clay mineral are preferably peeled to such an extent that six or less silicate layers of the layered clay mineral overlap each other on average. When the average exceeds six, the total surface area of the layered clay mineral reduces, and an interaction between the layered clay mineral and an organic component reduces, so the toughness of the pressure-sensitive adhesive may reduce. The average number of overlapping layers can be analyzed with an electron microscope (TEM).

The content of the above lipophilic layered clay mineral is preferably 0.5 to 20 parts by weight, more preferably 1 to 20 parts by weight, or still more preferably 2 to 10 parts by weight with respect to 100 parts by weight of the above pressure-sensitive adhesive composition. When the content is less than 0.5 part by weight, an effect of the present invention may not be sufficiently exerted. When the content is larger than 20 parts by weight, the viscosity of the pressure-sensitive adhesive layer increases, so an external appearance when the pressure-sensitive adhesive tape is applied may deteriorate.

As the base material sheet, any appropriate base material sheet may be employed. Examples thereof include a polyethylene terephthalate (PET) film, a polyethylene naphthalate (PEN) film, a polyether sulfone (PES) film, a polyether imide (PEI) film, a polysulfone (PSF) film, a polyphenylene sulfide (PPS) film, a polyether ether ketone (PEEK) film, a polyarylate (PAR) film, an aramide film, a polyimide film, and a liquid crystal polymer (LCP) film. In view of heat resistance, a film formed of a polyimide material is preferred.

Any appropriate thickness can be adopted as the thickness of the base material sheet. The thickness is preferably 10 to 250 µm.

In the pressure-sensitive adhesive tape of the present invention, it is important that the pieces of the above lipophilic layered clay mineral be arranged substantially perpendicular to the above base material sheet. A state where the pieces of the lipophilic layered clay mineral are arranged substantially perpendicular to the base material sheet can be found by observing a section of the pressure-sensitive adhesive tape with an electron microscope (SEM or TEM).

The phrase "arranged substantially perpendicular to the base material sheet" means that the pieces of the lipophilic layered clay mineral are arranged at an angle of preferably 60° to 120°, more preferably 70° to 110°, or still more preferably 80° to 100° relative to the principal surface of the base material sheet.

In the pressure-sensitive adhesive tape of the present invention, a ratio between pieces of the above lipophilic layered clay mineral arranged substantially perpendicular to the above base material sheet and pieces of the above lipophilic layered claymineral arranged in any other direction is such that the pieces of the lipophilic layered clay mineral arranged substantially perpendicular to the base material sheet account for preferably 50 wt% or more, more preferably 70 wt% or more, or still more preferably 90 wt% or more of the entire pieces of the lipophilic layered clay mineral.

Any appropriate method can be adopted as a method of producing the pressure-sensitive adhesive tape of the present invention as long as the pieces of the lipophilic layered clay mineral are arranged substantially perpendicular to the base material sheet. For example, the following method is employed. First, an upper portion of any substrate is coated with the pressure-sensitive adhesive composition containing the above lipophilic layered clay mineral, and the pressure-sensitive adhesive composition is dried so that a pressure-sensitive adhesive sheet in which the pieces of the lipophilic layered clay mineral are horizontally arranged may be produced. Several sheets are superimposed on each other to provide a laminated sheet. The resultant is inverted by 90° so that a pressure-sensitive adhesive layer in a state where the pieces of the above lipophilic layered clay mineral are perpendicularly arranged may be formed, and the pressure-sensitive adhesive layer is formed on the base material sheet. Alternatively, the pieces of the above lipophilic layered clay mineral can be perpendicularly arranged by: forming the pressure-sensitive adhesive composition containing the above lipophilic layered clay mineral on the base material sheet without applying any shear; and drying the pressure-sensitive adhesive composition.

In the pressure-sensitive adhesive tape of the present invention, a protective film may be used in order to protect the pressure-sensitive adhesive layer. Examples of the protective film include plastic films formed of polyvinyl chloride, a vinyl chloride copolymer, polyethylene terephthalate, polybutylene terephthalate, polyurethane, an ethylene-vinyl acetate copolymer, an ionomer resin, an ethylene-(meth)acrylic acid copolymer, an ethylene-(meth)acrylate copolymer, polystyrene, polycarbonate, or the like, each of which is subjected to releasing treatment with a silicone-based, long-chain alkyl-based, fluorine-based, aliphatic amide-based, or silica-based releasing agent. In addition, as the film of the polyolefin resin base such as polyethylene, polypropylene, polybutene, polybutadiene, and polymethyl pentene has a releasing property even without using a releasing treatment agent, and hence, the film alone can be used as a protective film. The thickness of the protective film is preferably about 10 to 100 µm.

The pressure-sensitive adhesive tape of the present invention is applicable to any appropriate application. The pressure-sensitive adhesive tape is suitably used in applications where heat resistance and a cohesive strength are required such as: the production of electronic parts; structures; and automobiles. The pressure-sensitive adhesive tape is particularly suitably used in applications where peeling is needed such as the production of an electronic part, a semiconductor device, or an electronic part for, for example, a flat display such as an LCD or PDP because the pressure-sensitive adhesive tape does not cause a problem referred to as "pressure-sensitive adhesive residue" upon peeling from an adherend.

### Examples

Hereinafter, the present invention is described more specifically by way of examples. However, the present invention is not limited by these examples. In addition, the terms "part (s)" in the examples refer to "part(s) by weight".

### <Observation of state where pieces of layered clay mineral are arranged>

The sectional structure of a pressure-sensitive adhesive layer was observed with an electron microscope (SEM) so that a state where the pieces of a layered clay mineral were arranged in the pressure-sensitive adhesive layer might be found. The state was evaluated on the basis of a direction relative to a substrate sheet.

### <Method for evaluation for pressure-sensitive adhesive residue>

A pressure-sensitive adhesive tape was brought into press contact with and stuck to a stainless sheet by reciprocating a 2-kg roller once on the stainless sheet. After the test piece had been left to stand at 175°C for 1 hour, the pressure-sensitive adhesive tape was peeled in the direction at 90° from the stainless sheet, and whether the pressure-sensitive adhesive tape could be peeled without leaving a pressure-sensitive adhesive residue on the stainless sheet was examined.
○: The pressure-sensitive adhesive tape could be peeled favorably without leaving a pressure-sensitive adhesive residue.
×: A pressure-sensitive adhesive residue was present.

### [Reference Example 1] Production of layered clay mineral-dispersed liquid

A SOMASIF MAE manufactured by CO-OP Chemical was used as a layered clay mineral. Inaddition, interlayer peeling was performed as a peeling approach by high-pressure shearing with a Nanomizer II manufactured by YOSHIDA KIKAI CO., LTD., whereby a layered clay mineral-dispersed liquid was produced.

### [Reference Example 2] Preparation of acrylic pressure-sensitive adhesive solution

An acrylic pressure-sensitive adhesive solution was prepared by uniformly mixing 2 parts of a polyisocyanate compound (manufactured by NIPPON POLYURETHANE INDUSTRY CO., LTD. , trade name: Colonate L) and 0.6 part of an epoxy-based compound (manufactured by Mitsubishi Gas Chemical Company, Inc., trade name: TETRAD-C) in 100 parts of an acrylic polymer obtained from a monomer mixed liquid composed of 100 parts of butyl acrylate and 3 parts of acrylic acid.

### [Example 1]

The layered clay mineral-dispersed liquid produced in Reference Example 1 was blended into the acrylic pressure-sensitive adhesive solution prepared in Reference Example 2 so that the amount of the layered clay mineral might be 5 parts with respect to 100 parts of the acrylic polymer of the acrylic pressure-sensitive adhesive solution. Then, the mixture was sufficiently stirred, whereby a pressure-sensitive adhesive solution (1) was produced.
One surface of a polyester film (manufactured by Mitsubishi Polyester Film Corp., trade name: MRF 50, thickness 50 µm, width 250mm) was treated with a silicone-based release agent. The silicone release-treated surface of the polyester film was coated with the pressure-sensitive adhesive solution (1), and the solution was dried, whereby a pressure-sensitive adhesive sheet (1) was produced. The pressure-sensitive adhesive sheet (1) was peeled from the release film, and sheets obtained by the peeling were superimposed on each other, whereby a laminated sheet (1) was produced. The laminated sheet (1) was cut so that a pressure-sensitive adhesive layer might have a thickness of 10 µm, a width of 50 mm, and a length of 200 mm after the laminated sheet (1) had been inverted by 90°. Then, the pressure-sensitive adhesive layer was formed by laminating the cut pieces on a polyimide film having a thickness of 25 µm (manufactured by DU PONT-TORAY CO., LTD., trade name: Kapton 100H). Further, an MRF 50 was stuck to the resultant, whereby a pressure-sensitive adhesive tape (1) was produced.
The resultant pressure-sensitive adhesive tape (1) was evaluated for a state where the pieces of the layered clay mineral were arranged and a pressure-sensitive adhesive residue. Table 1 shows the results.

### [Example 2]

A pressure-sensitive adhesive tape (2) was produced in the same manner as in Example 1 except that 10 parts of the layered clay mineral were blended.
The resultant pressure-sensitive adhesive tape (2) was evaluated for a state where the pieces of the layered clay mineral were arranged and a pressure-sensitive adhesive residue. Table 1 shows the results.

### [Example 3]

A pressure-sensitive adhesive tape (3) was produced in the same manner as in Example 1 except that 20 parts of the layered clay mineral were blended.
The resultant pressure-sensitive adhesive tape (3) was evaluated for a state where the pieces of the layered clay mineral were arranged and a pressure-sensitive adhesive residue. Table 1 shows the results.

### [Example 4]

A pressure-sensitive adhesive tape (4) was produced in the same manner as in Example 1 except that a silicone-based pressure-sensitive adhesive (manufactured by Dow Corning Toray Co., Ltd., trade name: SD-4587) was used instead of the acrylic pressure-sensitive adhesive solution.
The resultant pressure-sensitive adhesive tape (4) was evaluated for a state where the pieces of the layered clay mineral were arranged and a pressure-sensitive adhesive residue. Table 1 shows the results.

### [Example 5]

A pressure-sensitive adhesive tape (5) was produced in the same manner as in Example 2 except that a silicone-based pressure-sensitive adhesive (manufactured by Dow Corning Toray Co., Ltd., trade name: SD-4587) was used instead of the acrylic pressure-sensitive adhesive solution.
The resultant pressure-sensitive adhesive tape (5) was evaluated for a state where the pieces of the layered clay mineral were arranged and a pressure-sensitive adhesive residue. Table 1 shows the results.

### [Example 6]

A pressure-sensitive adhesive tape (6) was produced in the same manner as in Example 3 except that a silicone-based pressure-sensitive adhesive (manufactured by Dow Corning Toray Co., Ltd., trade name: SD-4587) was used instead of the acrylic pressure-sensitive adhesive solution.
The resultant pressure-sensitive adhesive tape (6) was evaluated for a state where the pieces of the layered clay mineral were arranged and a pressure-sensitive adhesive residue. Table 1 shows the results.

### [Comparative Example 1]

A pressure-sensitive adhesive tape (C1) was produced in the same manner as in Example 1 except that no layered clay mineral was blended.
The resultant pressure-sensitive adhesive tape (C1) was evaluated for a state where the pieces of the layered clay mineral were arranged and a pressure-sensitive adhesive residue. Table 1 shows the results.

### [Comparative Example 2]

The layered clay mineral-dispersed liquid produced in Reference Example 1 was blended into the acrylic pressure-sensitive adhesive solution prepared in Reference Example 2 so that the amount of the layered clay mineral might be 5 parts with respect to 100 parts of the acrylic polymer of the acrylic pressure-sensitive adhesive solution. Then, the mixture was sufficiently stirred, whereby a pressure-sensitive adhesive solution (1) was produced.
An upper portion of a polyimide film having a thickness of 25 µm (manufactured by DU PONT-TORAY CO., LTD., trade name: Kapton 100H) was coated with the above pressure-sensitive adhesive solution (1) so that the solution might have a thickness of 10 µm after drying. Then, the solution was dried. Further, an MRF 50 was stuck to the resultant, whereby a pressure-sensitive adhesive tape (C2) was produced.
The resultant pressure-sensitive adhesive tape (C2) was evaluated for a state where the pieces of the layered clay mineral were arranged and a pressure-sensitive adhesive residue. Table 1 shows the results.

### [Comparative Example 3]

A pressure-sensitive adhesive tape (C3) was produced in the same manner as in Comparative Example 2 except that 10 parts of the layered clay mineral were blended.
The resultant pressure-sensitive adhesive tape (C3) was evaluated for a state where the pieces of the layered clay mineral were arranged and a pressure-sensitive adhesive residue. Table 1 shows the results.

### [Comparative Example 4]

A pressure-sensitive adhesive tape (C4) was produced in the same manner as in Comparative Example 2 except that 20 parts of the layered clay mineral were blended.
The resultant pressure-sensitive adhesive tape (C4) was evaluated for a state where the pieces of the layered clay mineral were arranged and a pressure-sensitive adhesive residue. Table 1 shows the results.

**[Table 1]**

| | Pressure-sensitive adhesive composition | Loading of layered clay mineral (parts) | Arrangement of molecules of layered clay mineral | Pressure-sensitive adhesive residue |
|---|---|---|---|---|
| Example 1 | Acrylic | 5 | Perpendicular | ○ |
| Example 2 | Acrylic | 10 | Perpendicular | ○ |
| Example 3 | Acrylic | 20 | Perpendicular | ○ |
| Example 4 | Silicone-based | 5 | Perpendicular | ○ |
| Example 5 | Silicone-based | 10 | Perpendicular | ○ |
| Example 6 | Silicone-based | 20 | Perpendicular | ○ |
| Comparative Example 1 | Acrylic | 0 | - | × |
| Comparative Example 2 | Acrylic | 5 | Horizontal | × |
| Comparative Example 3 | Acrylic | 10 | Horizontal | × |
| Comparative Example 4 | Acrylic | 20 | Horizontal | × |

### Industrial Applicability

The pressure-sensitive adhesive tape of the present invention is suitably used in applications where heat resistance and a cohesive strength are required such as: the production of electronic parts; structures; and automobiles. The pressure-sensitive adhesive tape is particularly suitably used in the production of an electronic part, a semiconductor device, or an electronic part for, for example, a flat display such as an LCD or PDP.

## Claims

1. A pressure-sensitive adhesive tape comprising, on a base material sheet, a pressure-sensitive adhesive layer containing a pressure-sensitive adhesive composition and a lipophilic layered clay mineral dispersed in the pressure-sensitive adhesive composition, wherein pieces of the layered clay mineral are arranged substantially perpendicular to the base material sheet.

2. A pressure-sensitive adhesive tape according to claim 1, wherein the layered clay mineral comprises a smectite-based clay mineral and/or a mica-based clay mineral.

3. A pressure-sensitive adhesive tape according to claim 1 or 2, wherein 2 to 20 parts by weight of the layered clay mineral are incorporated into 100 parts by weight of the pressure-sensitive adhesive composition.

4. A pressure-sensitive adhesive tape according to any one of claims 1 to 3, wherein the pressure-sensitive adhesive composition comprises an acrylic pressure-sensitive adhesive composition formed of a monomer composition mainly composed of an alkyl (meth) acrylate ester of an alkyl alcohol having 4 to 14 carbon atoms.

5. A pressure-sensitive adhesive tape according to any one of claims 1 to 3, wherein the pressure-sensitive adhesive composition comprises a silicone-based pressure-sensitive adhesive composition.

6. A pressure-sensitive adhesive tape according to any one of claims 1 to 5, wherein the pressure-sensitive adhesive tape is used in producing an electronic part.
